# EUROPEAN PATENT APPLICATION

(11) **EP 4 819 816 A1**
(43) Date of publication of application: **07.10.2026**
(21) Application number: 26165374.5
(22) Date of filing: 17.03.2026
(51) Int. Cl.: H10K 59/80

(54) **DISPLAY APPARATUS, METHOD OF MANUFACTURING DISPLAY APPARATUS, AND ELECTRONIC APPARATUS**

(30) Priority: 04.04.2025 KR 20250044268
(71) Applicant: Samsung Display Co., Ltd., Yongin-si, Gyeonggi-do 17113 (KR)
(72) Inventor: CHOI, Youngeun, 17113 Yongin-si (KR); KIM, Dongchan, 17113 Yongin-si (KR); KIM, Seongkeun, 17113 Yongin-si (KR); BAE, Sungsoo, 17113 Yongin-si (KR); CHOI, Jiyong, 17113 Yongin-si (KR)
(74) Representative: Marks & Clerk LLP

(57) **Abstract**

A display apparatus, a method of manufacturing the display apparatus, and an electronic apparatus are provided. The display apparatus includes a substrate, a pixel electrode on the substrate, an opposite electrode on the pixel electrode, and an intermediate layer between the pixel electrode and the opposite electrode and including an emission layer, wherein the opposite electrode includes a first electrode layer directly contacting the intermediate layer and including silver (Ag) and lithium (Li), and a second electrode layer on the first electrode layer and including Li.

## Description

### BACKGROUND

### 1. Field

One or more embodiments relate to a display apparatus, a method of manufacturing the display apparatus, and an electronic apparatus, and for example, to a display apparatus, a method of manufacturing the display apparatus, and an electronic apparatus, having excellent or suitable optical efficiency and high stability.

### 2. Description of the Related Art

Display apparatuses are widely utilized in various applications, and demand for lighter and thinner designs continues to increase. As these apparatuses (devices) become thinner and lighter, their range of applications expands, driving research into new structural and material configurations.

A display apparatus may display an image by utilizing a display element including a pixel electrode, an opposite electrode, and an emission layer between the pixel electrode and the opposite electrode.

However, certain comparable configurations exhibit reduced optical efficiency due to high light absorption by materials utilized in the opposite electrode, such as magnesium (Mg).

The above information disclosed in this Background section is intended to enhance understanding of the background of the disclosure and may contain information that does not constitute prior art.

### SUMMARY

Aspects of one or more embodiments of the present disclosure are directed to a display apparatus having excellent or suitable optical efficiency and high stability. These characteristics may be achieved by the inclusion of a two-layer common electrode as part of the display element, including a first electrode layer including silver (Ag) and lithium (Li) and a second electrode layer on the first electrode layer including lithium (Li).

Aspects of embodiments of the present disclosure are directed to a method of manufacturing the display apparatus, and an electronic apparatus including the display apparatus.

However, the above aspects are merely examples, and the scope of the present disclosure is not necessarily limited thereto.

Additional aspects will be set forth in part in the description which follows and, in part, will be apparent from the description, or may be learned by practice of the presented embodiments of the disclosure.

According to one or more embodiments of the present disclosure, a display apparatus includes a substrate, a pixel electrode arranged on the substrate, an opposite electrode arranged on the pixel electrode, and an intermediate layer between the pixel electrode and the opposite electrode and including an emission layer, wherein the opposite electrode includes a first electrode layer directly contacting the intermediate layer and including silver (Ag) and lithium (Li), and a second electrode layer arranged on the first electrode layer and including Li.

In one or more embodiments, the intermediate layer may further include a hole transport layer arranged between the pixel electrode and the emission layer, and an electron transport layer arranged between the opposite electrode and the emission layer.

In one or more embodiments, the first electrode layer may directly contact the electron transport layer.

In one or more embodiments, the electron transport layer may include an organic material.

In one or more embodiments, the first electrode layer may include Li in an amount equal to or more than about 0.05 wt% and equal to or less than about 1.0 wt% based on the total weight of the first electrode layer.

In one or more embodiments, the thickness of the second electrode layer may be equal to or more than about 5 Å and equal to or less than about 20 Å.

In one or more embodiments, the first electrode layer may not include (e.g., may exclude) magnesium (Mg).

In one or more embodiments, the display apparatus may further include an encapsulation layer arranged on the opposite electrode and including at least one inorganic encapsulation layer and at least one organic encapsulation layer.

According to one or more embodiments of the present disclosure, a method of manufacturing a display apparatus includes forming an intermediate layer including an emission layer on a pixel electrode arranged on a substrate, forming a first electrode layer including silver (Ag) and lithium (Li) on the intermediate layer, and forming a second electrode layer including Li on the first electrode layer.

In one or more embodiments, the intermediate layer may further include a hole transport layer located between the pixel electrode and the emission layer and an electron transport layer arranged on the emission layer, the forming of the first electrode layer may include co-depositing Ag and Li on the electron transport layer, and the forming of the second electrode layer may include depositing Li on the first electrode layer.

In one or more embodiments, the electron transport layer may include an organic material.

In one or more embodiments, the first electrode layer may include Li in an amount equal to or more than about 0.05 wt% and equal to or less than about 1.0 wt% based on the total weight of the first electrode layer.

In one or more embodiments, the thickness of the second electrode layer may be equal to or more than about 5 Å and equal to or less than about 20 Å.

In one or more embodiments, the first electrode layer may not include (e.g., may exclude) magnesium (Mg).

According to one or more embodiments of the present disclosure, an electronic apparatus includes a processor and a display apparatus to be controlled by the processor, wherein the display apparatus includes a substrate, a pixel electrode arranged on the substrate, an opposite electrode arranged on the pixel electrode, and an intermediate layer between the pixel electrode and the opposite electrode and including an emission layer, wherein the opposite electrode includes a first electrode layer directly contacting the intermediate layer and including silver (Ag) and lithium (Li), and a second electrode layer arranged on the first electrode layer and including Li.

In one or more embodiments, the intermediate layer may further include a hole transport layer arranged between the pixel electrode and the emission layer, and an electron transport layer arranged between the opposite electrode and the emission layer.

In one or more embodiments, the first electrode layer may directly contact the electron transport layer.

In one or more embodiments, the first electrode layer may include Li in an amount equal to or more than about 0.05 wt% and equal to or less than about 1.0 wt% based on the total weight of the first electrode layer.

In one or more embodiments, the thickness of the second electrode layer may be equal to or more than about 5 Å and equal to or less than about 20 Å.

The first electrode layer may not include (e.g., may exclude) magnesium (Mg).

For example, the foregoing embodiments collectively illustrate that the disclosed structures and methods are directed toward improving optical efficiency and stability in display apparatuses by employing a two-layer opposite electrode configuration. In particular, the combination of a first electrode layer including silver (Ag) and lithium (Li) and a second electrode layer including Li provides reduced light absorption compared to comparable electrodes, while maintaining electrical performance and structural integrity. These features, along with optional layers such as hole transport and electron transport layers, enable thinner, lighter, and more reliable display devices suitable for integration into various electronic apparatuses.

Other aspects, features, and/or principles other than those described above will become apparent from the detailed description for implementing embodiments of the present disclosure, the claims, and the drawings.

At least some of the above and other features of the invention are set out in the claims.

### BRIEF DESCRIPTION OF THE DRAWINGS

The accompanying drawings are included to provide a further understanding of the present disclosure and are incorporated in and constitute a part of this specification. The drawings illustrate example embodiments of the present disclosure and, together with the description, serve to explain principles of the present disclosure. In the drawings:
FIG. 1A is a block diagram schematically illustrating an electronic apparatus according to one or more embodiments of the present disclosure;
FIG. 1B is a set of schematic diagrams illustrating electronic apparatuses according to one or more embodiments of the present disclosure;
FIG. 2 is a schematic plan view of a display apparatus according to one or more embodiments of the present disclosure;
FIG. 3 is an equivalent circuit diagram of a pixel circuit included in the display apparatus of FIG. 2, according to one or more embodiments of the present disclosure;
FIG. 4 is a schematic cross-sectional view taken along the line I-I' of FIG. 2, according to one or more embodiments of the present disclosure;
FIG. 5 is an enlarged cross-sectional view schematically illustrating the portion A of FIG. 4, according to one or more embodiments of the present disclosure;
FIG. 6 is a schematic cross-sectional view of a portion of a display apparatus according to a comparative example;
FIG. 7 is an enlarged cross-sectional view schematically illustrating the portion B of FIG. 6;
FIGS. 8 to 11 are cross-sectional views schematically illustrating a portion of a manufacturing process for the display apparatus of FIG. 4, according to one or more embodiments of the present disclosure.

### DETAILED DESCRIPTION

The present disclosure may be modified in many alternate forms, and thus specific embodiments will be illustrated in the drawings and described in more detail. It should be understood, however, that this is not intended to limit the present disclosure to the particular forms disclosed, but rather, is intended to cover all modifications, equivalents, and alternatives falling within the spirit and scope of the present disclosure.

Hereinafter, example embodiments will be described in more detail with reference to the accompanying drawings. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described.

Unless otherwise noted, like reference numerals denote like elements throughout the attached drawings and the written description, and thus, duplicative descriptions thereof may not be provided.

As used herein, the term "and/or" includes any and all combinations of one or more of the associated listed items. Unless otherwise apparent from the disclosure, expressions such as "at least one of," "a plurality of," "one of," and other prepositional phrases, when preceding a list of elements, should be understood as including the disjunctive if written as a conjunctive list and vice versa. For example, the expressions "at least one of a, b, or c," "at least one of a, b, and/or c," "one selected from the group consisting of a, b, and c," "at least one selected from among a, b, and c," "at least one from among a, b, and c," "one from among a, b, and c", "at least one of a to c" indicates only a, only b, only c, both a and b, both a and c, both b and c, all of a, b, and c, or variations thereof.

The disclosure may undergo various modifications and have several embodiments, and specific embodiments will be illustrated in the drawings and described in detail in the detailed description. The effects and features of the disclosure, and methods to achieve them will become more apparent from the embodiments described in detail below with reference to the drawings. However, the disclosure may not necessarily be limited to the embodiments disclosed below but may be implemented in various forms.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

As used herein, the singular forms "a," "an" and "the" are intended to include the plural forms as well, unless the context clearly indicates otherwise.

It will be further understood that the terms "comprises," "comprising," "includes," "including," "have," and "having," when used in this specification, specify the presence of the stated features, integers, steps, operations, elements, and/or components, but do not preclude the presence or addition of one or more other features, integers, steps, operations, elements, components, and/or groups thereof. Additionally, the terms "comprise(s)/comprising," "include(s)/including," "have/has/having" or similar terms include or support the terms "consisting of" and "consisting essentially of," indicating the presence of stated features, integers, steps, operations, elements, and/or components, without or essentially without the presence of other features, integers, steps, operations, elements, components, and/or groups thereof.

In the present specification, "A and/or B" indicates A, B, or A and B. In addition, "at least one of A and B" indicates A, B, or A and B.

It will be understood that when an element, such as an area, layer, film, region or portion, is referred to as being "on" or "connected to" another element, it can be directly on or connected to the other element, or one or more intervening elements may be present. In contrast, when an element or layer is referred to as being "directly on," "directly connected to", or "immediately adjacent to" another element or layer, there are no intervening elements or layers present. In addition, it will also be understood that when an element is referred to as being "between" two elements, it can be the only element between the two elements, or one or more intervening elements may also be present.

In the present specification, when films, regions, components, *etc.,* are "electrically connected to each other," this indicates a case where the films, the regions, or the components are electrically directly connected to each other, and/or a case where another film, another region, or another component is between the films, the regions, or the components and thus the films, the regions, or the components are electrically indirectly connected to each other.

Spatially relative terms, such as "on," "below," "lower," "under," "above," "upper," and the like, may be used herein for ease of explanation to describe one element or feature's relationship to another element(s) orfeature(s) as illustrated in the figures. It will be understood that the spatially relative terms are intended to encompass different orientations of the device in use or in operation, in addition to the orientation depicted in the drawings. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (*e.g*., rotated 90 degrees or at other orientations) and the spatially relative descriptors used herein should be interpreted accordingly.

In the present specification, the x-axis, the y-axis, and the z-axis are not limited to three axes in an orthogonal coordinate system but may be interpreted in a broader sense including such. For example, the x-axis, the y-axis, and the z-axis may be orthogonal to each other, or may refer to different directions that are not orthogonal to each other.

In the context of the present disclosure and unless otherwise defined, a plan view is an orthographic projection of a three-dimensional object from the position of a horizontal plane through the object. That is, it is a top-down view, showing the layout and spatial relationships of various elements within the object or structure. A plan view based on the z-axis direction refers to a top-down view of the display panel, as if looking directly down onto the surface from above. In this context, z-axis direction is the direction perpendicular or normal to the plane defined by the x-axis direction and the y-axis direction. This refers to that in a plan view, the arrangement of sub-pixels, pads, and other components as they are laid out on the substrate can be seen, without any perspective distortion.

In the present specification, if (*e.g.,* when) one or more embodiments may be implemented differently, a specific process order may be performed differently from the described order. For example, two processes described consecutively may be performed substantially concurrently (*e.g.,* simultaneously) or in an order opposite to the described order, unless otherwise apparent from the disclosure.

Hereinafter, embodiments will be described in more detail with reference to the accompanying drawings, and when referring to the drawings, the same or corresponding components will be given the same reference numerals, and redundant descriptions thereof may not be provided. For convenience of description, the components in the drawings may be exaggerated or reduced in size for clarity. For example, the size and thickness of each component shown in the drawings may be shown for convenience of description, and the disclosure may not necessarily be limited to what is shown.

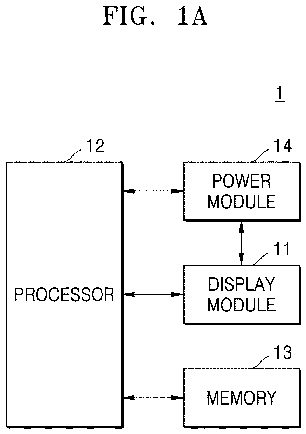

FIG. 1A is a block diagram schematically illustrating an electronic apparatus 1 according to one or more embodiments of the present disclosure. The electronic apparatus 1 according to one or more embodiments may include modules having other additional functions besides a display module 11. For example, as shown in FIG. 1A, the electronic apparatus 1 may include the display module 11, a processor 12, a memory 13, and a power module 14.

The processor 12 may control the components of the electronic apparatus 1. The processor 12 may include at least one of a central processing unit (CPU), an application processor (AP), a graphics processing unit (GPU), a communication processor (CP), an image signal processor (ISP), and a controller.

The memory 13 may store data information for the operation of the processor 12 or the display module 11. When the processor 12 executes an application stored in the memory 13, data signals and/or input control signals for an image may be transmitted to the display module 11, and the display module 11 may process the provided signals to output image information.

The power module 14 may include a power supply module, such as a power adapter or a battery device, and a power conversion module that converts power supplied by the power supply module to generate power for the operation of the electronic apparatus 1.

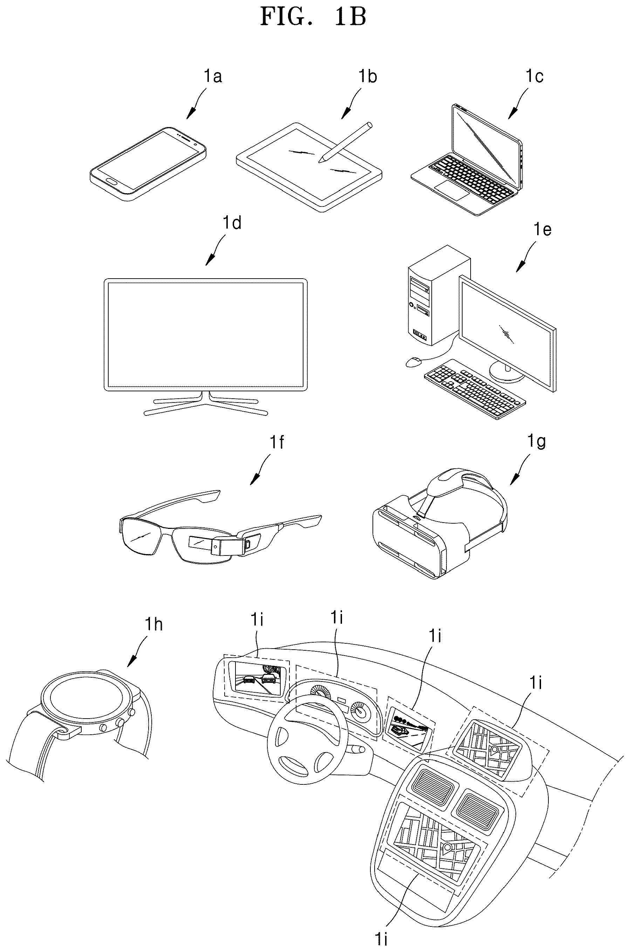

FIG. 1B is a set of schematic diagrams illustrating electronic apparatuses 1 according to one or more embodiments of the present disclosure. Referring to FIG. 1B, the electronic apparatuses 1 including the display module 11 may include not only image display electronic apparatuses such as a smartphone 1a, a tablet personal computer (PC) 1b, a laptop 1c, a television (TV) 1d, a desktop monitor 1e, and/or the like, but also wearable electronic apparatuses including a display module such as smart glasses 1f, a head mounted display 1g, a smart watch 1h, and automotive electronic apparatuses 1i including a display module in an instrument panel, a center fascia, a Center Information Display (CID) arranged at a dashboard, a room mirror display, and/or the like of an automobile.

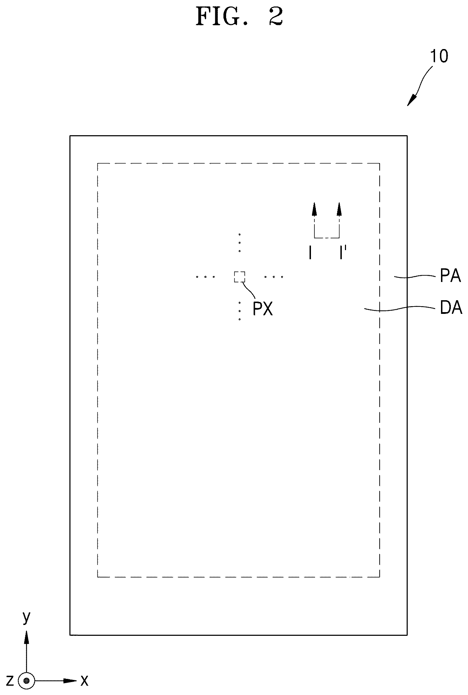

Furthermore, the display module 11 may include a display apparatus 10 (*see, e.g.,* FIG. 2). The display apparatus 10 may be applied to one or more suitable electronic apparatuses 1. For example, the electronic apparatus 1 may include the display apparatus 10, and may further include modules or devices having other additional functions besides the display apparatus 10. For example, the electronic apparatus 1 may include the display apparatus 10, the processor 12, the memory 13, and the power module 14, and the display apparatus 10 may be controlled by the processor 12. The description below will mainly focus on the display apparatus 10.

As shown in FIG. 2, the display apparatus 10 may include a display area DA in which a plurality of pixels PX are arranged and a peripheral area PA located outside the display area DA. For example, the peripheral area PA may entirely be around (*e.g.,* surround) the display area DA.

Each pixel PX of the display apparatus 10 may be an area capable of emitting light of a certain color, and the display apparatus 10 may provide an image by using light emitted from the pixels PX. For example, each pixel PX may be to emit red light, green light, or blue light. The display area DA may have a polygonal shape such as a rectangle, as shown in FIG. 2. For example, the display area DA may have a rectangular shape in which the horizontal length is less than the vertical length, a rectangular shape in which the horizontal length is greater than the vertical length, or a square shape. Alternatively, in one or more embodiments, the display area DA may have other shapes such as an oval or a circular shape.

The peripheral area PA may be a non-display area where pixels PX are not arranged. Drivers and/or the like for providing electrical signals or power to the pixels PX may be arranged in the peripheral area PA. A plurality of pads, which are areas to which an electronic element or a printed circuit board may be electrically connected, may be arranged in the peripheral area PA. Each pad may be spaced and/or apart (*e.g.,* spaced apart or separated) from one another in the peripheral area PA and may be electrically connected to a printed circuit board or an integrated circuit element.

Hereinafter, an organic light-emitting display apparatus will be described as an example of the display apparatus 10 according to one or more embodiments, but the display apparatus 10 of the disclosure is not limited thereto. In one or more embodiments, the display apparatus 10 of the disclosure may be an inorganic light-emitting display or a display apparatus such as a quantum dot light-emitting display. For example, the emission layer of the display element included in the display apparatus 10 may include an organic material or an inorganic material. Also, the display apparatus 10 may include an emission layer and a quantum dot layer arranged on the path of light emitted from the emission layer.

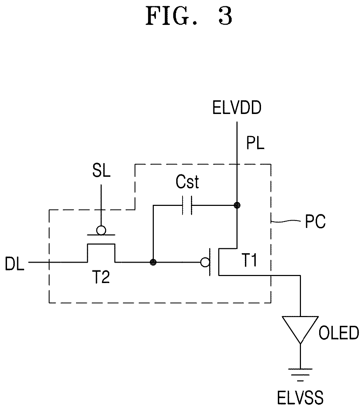

FIG. 3 is an equivalent circuit diagram of a pixel circuit PC included in the display apparatus 10 of FIG. 2, according to one or more embodiments of the present disclosure. The pixel circuit PC may be electrically connected to a display element, and one display element may correspond to one pixel. In FIG. 3, an organic light-emitting diode OLED is shown as the display element. In one or more embodiments, the display element may be to emit red light, green light, or blue light.

The pixel circuit PC may include a first transistor T1, a second transistor T2, and a storage capacitor Cst. The second transistor T2 may be a switching transistor, may be connected to a scan line SL and a data line DL, and may be turned on by a switching signal input from the scan line SL to transmit a data signal input from the data line DL to the first transistor T1. The storage capacitor Cst may have one end electrically connected to the second transistor T2 and the other end electrically connected to a driving voltage line PL, and may store a voltage corresponding to the difference between the voltage received from the second transistor T2 and a driving power voltage ELVDD supplied to the driving voltage line PL.

The first transistor T1 may be a driving transistor, may be connected to the driving voltage line PL and the storage capacitor Cst, and may control the magnitude of a driving current flowing from the driving voltage line PL to the organic light-emitting diode OLED in correspondence to the voltage value stored in the storage capacitor Cst. The organic light-emitting diode OLED may be to emit light having a certain luminance according to the driving current. The opposite electrode of the organic light-emitting diode OLED may receive an electrode power voltage ELVSS.

Although it is described with reference to FIG. 3 that the pixel circuit PC includes two transistors and one storage capacitor, the disclosure is not limited thereto. For example, the number of transistors or the number of storage capacitors may be variously changed according to the design of the pixel circuit PC.

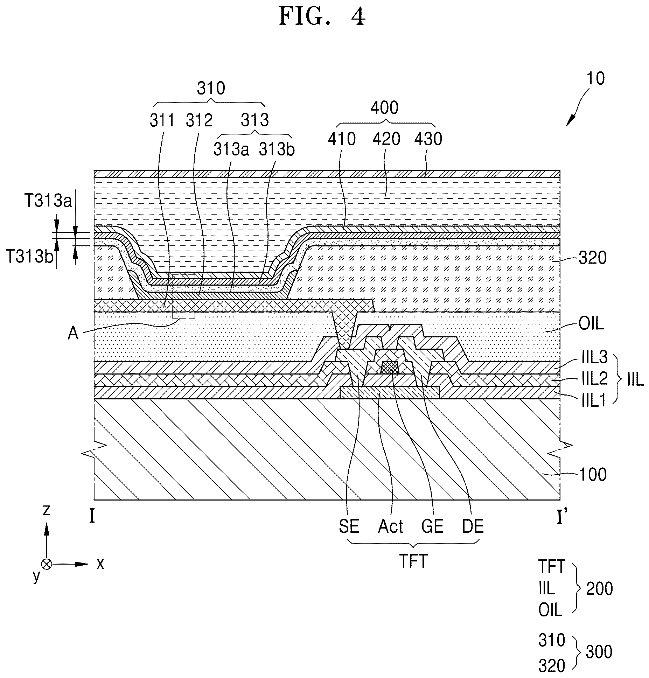

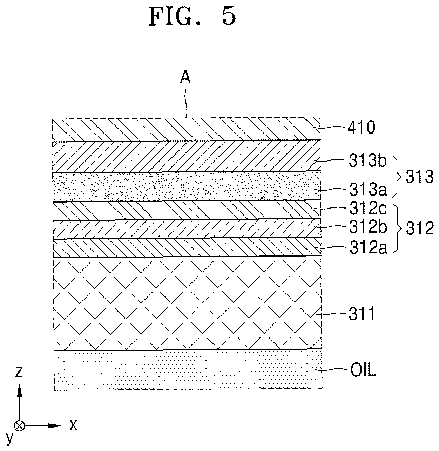

FIG. 4 is a schematic cross-sectional view taken along the line I-I' of the display apparatus 10 of FIG. 2, according to one or more embodiments of the present disclosure. FIG. 5 is an enlarged cross-sectional view of the portion A of FIG. 4, according to one or more embodiments of the present disclosure. In addition, as recognized by those skilled in the art, the display apparatus 10 may further include one or more suitable other components besides the components shown in FIG. 4.

As shown in FIG. 4, the display apparatus 10 may include a substrate 100, a pixel circuit layer 200, a display element layer 300, and an encapsulation layer 400. Because the display apparatus 10 includes the substrate 100, the substrate 100 may be described to have the display area DA and the peripheral area PA. Hereinafter, for convenience, the substrate 100 will be described as having the display area DA and the peripheral area PA.

The substrate 100 may include glass, metal, or polymer resin. The substrate 100 may have flexible or bendable characteristics. In such embodiments, the substrate 100 may include polymer resins such as polyether sulfone, polyacrylate, polyetherimide, polyethylene naphthalate, polyethylene terephthalate, polyphenylene sulfide, polyarylate, polyimide, polycarbonate, and/or cellulose acetate propionate. However, one or more suitable modifications are possible, such as the substrate 100 having a multi-layered structure including two layers and a barrier layer between the two layers. The two layers each include the polymer resin, and the barrier layer includes an inorganic material (such as silicon oxide (SiOₓ), silicon nitride (SiN_{X}), or silicon oxynitride (SiO_{X}N_{Y})).

The pixel circuit layer 200 may be arranged on the substrate 100. The pixel circuit layer 200 may include a transistor TFT, an inorganic insulating layer IIL, and an organic insulating layer OIL. The transistor TFT may include a semiconductor layer Act, a gate electrode GE, a source electrode SE, and a drain electrode DE. The inorganic insulating layer IIL may include a gate insulating layer IIL1, a first interlayer insulating layer IIL2, and a second interlayer insulating layer IIL3. For convenience of illustration, FIG. 4 shows one transistor TFT, which may correspond to the first transistor T1 (*see, e.g.,* FIG. 3) described above.

The semiconductor layer Act may be arranged on the substrate 100. The semiconductor layer Act may include polysilicon. In one or more embodiments, the semiconductor layer Act may include amorphous silicon, an oxide semiconductor, an organic semiconductor, and/or the like. In one or more embodiments, the semiconductor layer Act may include a channel region and a source region and a drain region arranged on both sides (*e.g.,* opposite sides) of the channel region, respectively.

The gate insulating layer IIL1 may be arranged on the semiconductor layer Act and the substrate 100. The gate insulating layer IIL1 may include an inorganic insulating material such as silicon oxide (SiO_{X}), silicon nitride (SiN_{X}), silicon oxynitride (SiO_{X}N_{Y}), and/or the like. For example, the gate insulating layer IIL1 may have a single-layered or multi-layered structure including the material described above. An insulating layer including such an inorganic insulating material may be formed through a method such as chemical vapor deposition. This process may also be used in the one or more embodiments and variations thereof described in more detail below.

In FIG. 4, the gate insulating layer IIL1 is shown as having a shape corresponding to the entire surface of the substrate 100 and having a structure with contact holes formed in preset portions, but the disclosure is not necessarily limited thereto. For example, the gate insulating layer IIL1 may be patterned in substantially the same shape as the gate electrode GE.

The gate electrode GE may be arranged on the gate insulating layer IIL1. For example, insulation between the semiconductor layer Act and the gate electrode GE may be provided by (secured by) the gate insulating layer IIL1 being located between the semiconductor layer Act and the gate electrode GE. The gate electrode GE may overlap the channel region of the semiconductor layer Act. The gate electrode GE may include a low-resistance metal material. In one or more embodiments, the gate electrode GE may include a conductive material including molybdenum (Mo), aluminum (Al), copper (Cu), titanium (Ti), and/or the like, and may have a single-layered or multi-layered structure including the conductive material.

The first interlayer insulating layer IIL2 may be arranged on the gate electrode GE and the gate insulating layer IIL1. The first interlayer insulating layer IIL2 may include an inorganic insulating material such as silicon oxide (SiOₓ), silicon nitride (SiNₓ), silicon oxynitride (SiOₓN_{y}), and/or the like. For example, the first interlayer insulating layer IIL2 may have a single-layered or multi-layered structure including the material described above.

The source electrode SE and the drain electrode DE may be arranged on the first interlayer insulating layer IIL2. Each of the source electrode SE and the drain electrode DE may be connected to the semiconductor layer Act through contact holes formed in the gate insulating layer IIL1 and the first interlayer insulating layer IIL2. At least one of the source electrode SE and/or the drain electrode DE may include a conductive material including molybdenum (Mo), aluminum (Al), copper (Cu), titanium (Ti), and/or the like, and may have a single-layered or multi-layered structure including the conductive material. In one or more embodiments, at least one of the source electrode SE and/or the drain electrode DE may have a multi-layered structure of Ti/Al/Ti.

However, the disclosure is not necessarily limited thereto. For example, the transistor TFT may include only one of the source electrode SE and/or the drain electrode DE, or may not include (*e.g.,* may exclude) either of them. For example, one transistor TFT may not have a drain electrode DE, and another transistor TFT connected to this transistor TFT may not have a source electrode SE, and the semiconductor layers Act of these two transistors may be connected to each other. This connection structure may have the same effect as if (*e.g.,* when) one transistor TFT has a source electrode SE and another transistor TFT has a drain electrode DE, and the source electrode SE of one transistor TFT is connected to the drain electrode DE of the other transistor TFT.

The second interlayer insulating layer IIL3 may be arranged on the source electrode SE, the drain electrode DE, and the first interlayer insulating layer IIL2. The second interlayer insulating layer IIL3 may include an inorganic insulating material such as silicon oxide (SiOₓ), silicon nitride (SiNₓ), and/or silicon oxynitride (SiOₓN_{y}). For example, the second interlayer insulating layer IIL3 may have a single-layered or multi-layered structure including the material described above.

An organic insulating layer OIL may be arranged on the second interlayer insulating layer IIL3. The organic insulating layer OIL may function to generally planarize the upper portion of the pixel circuit layer 200. The organic insulating layer OIL may include an organic material such as acryl, benzocyclobutene (BCB), hexamethyl disiloxane (HMDSO), and/or the like. In FIG. 4, the organic insulating layer OIL is shown as a single layer. However, the organic insulating layer OIL may have a plurality of layers, and one or more suitable modifications are possible.

The display element layer 300 may be arranged on the pixel circuit layer 200. The display element layer 300 may include a display element 310 and a pixel-defining layer 320. For example, the display element 310 may be arranged on the substrate 100. The display element 310 may be electrically connected to the transistor TFT. The display element 310 may be an organic light-emitting diode having, for example, a pixel electrode 311, an opposite electrode 313, and an intermediate layer 312 located therebetween and including an emission layer. The description that the display element 310 is electrically connected to the transistor TFT may be understood as the pixel electrode 311 of the organic light-emitting diode being electrically connected to the transistor TFT.

For example, the pixel electrode 311 may be arranged on the substrate 100. The pixel electrode 311 may contact one of the source electrode SE and/or the drain electrode DE through a contact hole formed in the second interlayer insulating layer IIL3 and the organic insulating layer OIL, in order to be electrically connected to the transistor TFT. The pixel electrode 311 may include conductive oxides such as indium tin oxide (ITO), indium zinc oxide (IZO), zinc oxide (ZnO), indium oxide (In₂O₃), indium gallium oxide (IGO), and/or aluminum zinc oxide (AZO). In one or more embodiments, the pixel electrode 311 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or compounds thereof. In one or more embodiments, the pixel electrode 311 may further include a layer formed of ITO, IZO, ZnO, or In₂O₃ above/below the reflective layer.

The pixel-defining layer 320 may cover an edge of the pixel electrode 311. The pixel-defining layer 320 may include a pixel opening, and the pixel opening may overlap the pixel electrode 311. For example, the pixel opening may expose the central portion of the pixel electrode 311 of the display element 310, and at least a portion of the intermediate layer 312 of the display element 310 may be located within the pixel opening. The emission area of light emitted from the display element 310 may be defined by the pixel opening. In FIG. 4, the entire intermediate layer 312 is shown as being located within the pixel opening, but the disclosure is not necessarily limited thereto. For example, the intermediate layer 312 may be integrally provided across a plurality of pixel electrodes 311. Accordingly, only a portion of the intermediate layer 312 may be located within the pixel opening.

Also, as shown in FIG. 4, the pixel-defining layer 320 may increase the distance between the edge of the pixel electrode 311 and the opposite electrode 313 above the pixel electrode 311. This may prevent or reduce the occurrence of arcs, and/or the like, at the edge of the pixel electrode 311. The pixel-defining layer 320 may include an organic insulating material such as polyimide, hexamethyldisiloxane (HMDSO), and/or the like. In one or more embodiments, the pixel-defining layer 320 may include a light-blocking material.

The opposite electrode 313 may be arranged on the pixel electrode 311. The opposite electrode 313 may be integrally provided across the entire surface of the display apparatus 10, and accordingly, may be commonly provided for a plurality of display elements 310. For example, the opposite electrode 313 may be integrally provided across the plurality of display elements 310. Therefore, the opposite electrode 313 may correspond to the plurality of pixel electrodes 311. In one or more embodiments, the opposite electrode 313 may include a plurality of sub-electrode layers stacked along the thickness direction (*e.g.,* the z-axis direction) of the substrate 100. For example, the opposite electrode 313 may include a first electrode layer 313a and a second electrode layer 313b. A detailed description of the first electrode layer 313a and the second electrode layer 313b of the opposite electrode 313 will be provided below.

An intermediate layer 312 including an emission layer is between the pixel electrode 311 and the opposite electrode 313. For example, as shown in FIG. 5, the intermediate layer 312 may include a hole transport layer 312a, an emission layer 312b, and an electron transport layer 312c.

The emission layer 312b may be to emit red light, green light, or blue light. The emission layer 312b may include a host material and a dopant material. The emission layer 312b may be formed using a phosphorescent or fluorescent emission material as a dopant in the host material. The emission layer 312b may be formed including a thermally activated delayed fluorescence (TADF) dopant in the host material. The color of light emitted from the emission layer 312b may be determined by a combination of the host material and the dopant material, and/or the like.

Generally utilized and/or generally available (e.g., suitable) materials may be used as the host material and the dopant material of the emission layer 312b. For example, the host material of the emission layer 312b may include at least one of fluoranthene derivatives, pyrene derivatives, arylacetylene derivatives, anthracene derivatives, fluorene derivatives, perylene derivatives, and chrysene derivatives. For example, the dopant material of the emission layer 312b may include at least one of styryl derivatives (*e.g.,* 1,4-bis[2-(3-N-ethylcarbazoryl)vinyl]benzene (BCzVB), 4-(di-p-tolylamino)-4'-[(di-p-tolylamino)styryl]stilbene (DPAVB), and N-(4-((E)-2-(6-((E)-4-(diphenylamino)styryl)naphthalen-2-yl)vinyl)phenyl)-N-phenylbenzenamine (N-BDAVBi)), perylene and derivatives thereof (*e.g.,* 2, 5, 8, 11-Tetra-t-butylperylene (TBP)), and/or pyrene and derivatives thereof (*e.g.,* 1,1-dipyrene, 1,4-dipyrenylbenzene, 1,4-Bis(N, N-Diphenylamino)pyrene, and/or N1,N6-di(naphthalen-2-yl)-N1,N6-diphenylpyrene-1,6-diamine). However, the disclosure is not necessarily limited thereto.

Functional layers may be arranged below and/or above the emission layer 312b. For example, a hole transport layer 312a may be between the pixel electrode 311 and the emission layer 312b, and an electron transport layer 312c may be between the emission layer 312b and the opposite electrode 313. Each of the hole transport layer 312a and the electron transport layer 312c may be integrally formed across a plurality of pixel electrodes 311, or may be patterned to correspond to each of the plurality of pixel electrodes 311.

The hole transport layer 312a may include a hole transport material, and the hole transport material may include at least one of carbazole-based derivatives such as N-phenylcarbazole, or polyvinylcarbazole, fluorene-based derivatives, and/or triphenylamine-based derivatives such as N,N'-bis(3-methylphenyl)-N,N'-diphenyl-[1,1-biphenyl]-4,4'-diamine (TPD), or 4,4',4"-tris(N-carbazolyl)triphenylamine (TCTA), N,N'-di(naphthalene-1-yl)-N,N'-diphenyl-benzidine (NPB), 4,4'-Cyclohexylidene bis[N,N-bis(4-methylphenyl)benzenamine] (TAPC), 4,4'-Bis[N,N'-(3-tolyl)amino]-3,3'-dimethylbiphenyl (HMTPD), 1,3-Bis(N-carbazolyl)benzene (mCP), 9-(4-tert-Butylphenyl)-3,6-bis(triphenylsilyl)-9H-carbazole (CzSi), and/or 4,4',4"-[tris(3-methylphenyl)phenylamino] triphenylamine (m-MTDATA). However, the disclosure is not necessarily limited thereto. In one or more embodiments, the hole transport layer 312a may (or may also) include 4,4',4"-tris(N-carbazolyl)triphenylamine (TCTA).

The electron transport layer 312c may include an organic material. For example, the electron transport layer 312c may include an electron transport material, and the electron transport material may include a triazine-based compound or an anthracene-based compound. For example, the electron transport material may include at least one of Tris(8-hydroxyquinolinato)aluminum (Alq₃), 1,3,5-tri[(3-pyridyl)-phen-3-yl]benzene, 2,4,6-tris(3'-(pyridin-3-yl)biphenyl-3-yl)-1,3,5-triazine, 2-(4-(N-phenylbenzoimidazolyl-1-ylphenyl)-9,10-dinaphthylanthracene, 1,3,5-tris(1-phenyl-1H-benzo[d]imidazol-2-yl)benzene (TPBi), 2,9-Dimethyl-4,7-diphenyl-1,10-phenanthroline (BCP), 4,7-Diphenyl-1,10-phenanthroline (Bphen), 3-(4-Biphenylyl)-4-phenyl-5-tert-butylphenyl-1,2,4-triazole (TAZ), 4-(Naphthalen-1-yl)-3,5-diphenyl-4H-1,2,4-triazole (NTAZ), 2-(4-Biphenylyl)-5-(4-tert-butylphenyl)-1,3,4-oxadiazole (tBu-PBD), Bis(2-methyl-8-quinolinolato-N1,O8)-(1,1'-Biphenyl-4-olato)aluminum (BAlq), berylliumbis(benzoquinolin-10-olate) (Bebq2), 9,10-di(naphthalene-2-yl)anthracene (ADN), diphenyl(4-(triphenylsilyl)phenyl)phosphine oxide (TSPO1), and/or 2,4,6-Tris(3-(pyrimidin-5-yl)phenyl)-1,3,5-triazine (TPM-TAZ). However, the disclosure is not necessarily limited thereto. In one or more embodiments, the electron transport layer 312c may (or may also) include at least one of lithium quinolate (LiQ) and/or 2,4,6-tri([1,1'-biphenyl]-3-yl)-1,3,5-triazine (T2T).

In one or more embodiments, in FIG. 5, the intermediate layer 312 is shown as including one emission layer, but the disclosure is not necessarily limited thereto. The intermediate layer 312 may include a plurality of emission layers. For example, the display element 310 may be provided with a tandem structure. For example, the intermediate layer 312 may include a lower emission layer and an upper emission layer. The lower emission layer may be (is) arranged on the pixel electrode 311, and the upper emission layer may be arranged on the lower emission layer to overlap the lower emission layer. The upper emission layer may be to emit light of the same color as light emitted by the lower emission layer. The lower emission layer may constitute a first emission unit, and the upper emission layer may constitute a second emission unit.

In such embodiments, a charge generation layer (CGL) may be arranged between the lower emission layer and the upper emission layer. The charge generation layer may serve to supply charges to the first emission unit and the second emission unit. Accordingly, the emission efficiency of the display element 310 having a structure in which a plurality of emission layers are stacked may be further enhanced. The charge generation layer may include an n-type (kind) charge generation layer for supplying electrons to the first emission unit and a p-type (kind) charge generation layer for supplying holes to the second emission unit. Accordingly, an additional functional layer may be arranged between the lower emission layer and the charge generation layer, and the functional layer between the lower emission layer and the charge generation layer may include an electron transport material and/or an electron injection material. An additional functional layer may also be arranged between the upper emission layer and the charge generation layer, and the functional layer between the upper emission layer and the charge generation layer may include a hole transport material and/or a hole injection material.

Each of the lower emission layer and the upper emission layer of the tandem structure may be integrally provided across a plurality of pixel electrodes 311, and each of the functional layers (*e.g.,* hole transport layer and/or electron transport layer) and the charge generation layer of the tandem structure may be integrally provided across a plurality of pixel electrodes 311. Alternatively, in one or more embodiments, each of the lower emission layer and the upper emission layer of the tandem structure may be patterned to correspond to each of the plurality of pixel electrodes 311, while each of the functional layers (*e.g.,* the hole transport layer and/or the electron transport layer) and the charge generation layer of the tandem structure may be integrally provided across the plurality of pixel electrodes 311.

Because the display element 310 may be easily damaged by moisture or oxygen from the outside, an encapsulation layer 400 may cover and protect the display elements 310. The encapsulation layer 400 may include at least one inorganic encapsulation layer and at least one organic encapsulation layer. For example, as shown in FIG. 4, the encapsulation layer 400 may include a first inorganic encapsulation layer 410, an organic encapsulation layer 420, and a second inorganic encapsulation layer 430.

The first inorganic encapsulation layer 410 covers the opposite electrode 313 and may include silicon oxide (SiOₓ), silicon nitride (SiNₓ), silicon oxynitride (SiOₓN_{y}), and/or the like. However, other layers such as a capping layer may be located between the first inorganic encapsulation layer 410 and the opposite electrode 313 as desired and/or needed. Because the first inorganic encapsulation layer 410 is formed along the structure therebelow, an upper surface of the first inorganic encapsulation layer 410 may not be flat, as shown, *e.g*., in FIG. 4. The organic encapsulation layer 420 covers the first inorganic encapsulation layer 410 and, unlike the first inorganic encapsulation layer 410, may have an approximately flat upper surface. The organic encapsulation layer 420 may include one or more materials selected from the group consisting of polyethylene terephthalate, polyethylene naphthalate, polycarbonate, polyimide, polyethylene sulfonate, polyoxymethylene, polyarylate, and HMDSO. The second inorganic encapsulation layer 430 covers the organic encapsulation layer 420 and may include silicon oxide (SiOₓ), silicon nitride (SiNₓ), silicon oxynitride (SiOₓN_{y}), and/or the like.

The encapsulation layer 400 may thus include the first inorganic encapsulation layer 410, the organic encapsulation layer 420, and the second inorganic encapsulation layer 430, and through such a multi-layered structure, even if (*e.g.,* when) cracks occur in the encapsulation layer 400, these cracks may be prevented from connecting or the likelihood of connection may be reduced between the first inorganic encapsulation layer 410 and the organic encapsulation layer 420 and/or between the organic encapsulation layer 420 and the second inorganic encapsulation layer 430. This may prevent, reduce, or minimize the formation of paths through which moisture or oxygen from the outside may penetrate into the interior of the display apparatus 10.

In one or more embodiments, as described above, the opposite electrode 313 may include a plurality of sub-electrode layers. For example, the opposite electrode 313 may include a first electrode layer 313a and a second electrode layer 313b. The first electrode layer 313a may directly contact (*e.g.,* directly contacts) the intermediate layer 312, and the second electrode layer 313b may be arranged on the first electrode layer 313a. For example, the first electrode layer 313a may directly contact (*e.g.,* directly contacts) the electron transport layer 312c, and the second electrode layer 313b may directly contact the first electrode layer 313a.

The first electrode layer 313a may include silver (Ag) and lithium (Li). The first electrode layer 313a may not include (*e.g.,* may exclude) magnesium (Mg). For example, the first electrode layer 313a may be a layer composed of silver (Ag) doped with a small amount of lithium (Li). Because the work function of silver (Ag) is about 4.52 eV, a layer composed only of silver (Ag) may not facilitate the outflow of electrons or anions. However, because the work function of lithium (Li) is about 2.90 eV, a layer composed of silver (Ag) but doped with a small amount of lithium (Li) may have a relatively low work function, making the outflow of electrons or anions easier. Because the first electrode layer 313a includes silver (Ag) and lithium (Li), the injection of electrons or anions from the opposite electrode 313 to the intermediate layer 312 may be facilitated. Furthermore, because the first electrode layer 313a does not include magnesium (Mg), the optical efficiency of the display apparatus 10 may be excellent or suitable.

The second electrode layer 313b may include lithium (Li). The second electrode layer 313b need not include (*e.g.,* may exclude) magnesium (Mg). For example, the second electrode layer 313b may be a layer composed only of lithium (Li). A highly reactive metal included in the opposite electrode 313, for example, a reactive metal, may capture oxygen or moisture that has penetrated into the interior of the display apparatus 10 if (*e.g.,* when) oxygen or moisture infiltrates the interior of the display apparatus 10, thereby preventing or reducing the likelihood of damage to the intermediate layer 312. Accordingly, the stability of the display apparatus 10 may be high. The second electrode layer 313b of the opposite electrode 313 increases the amount of reactive metal (*e.g.,* lithium (Li)) included in the opposite electrode 313, thereby providing high or improved stability to the display apparatus 10.

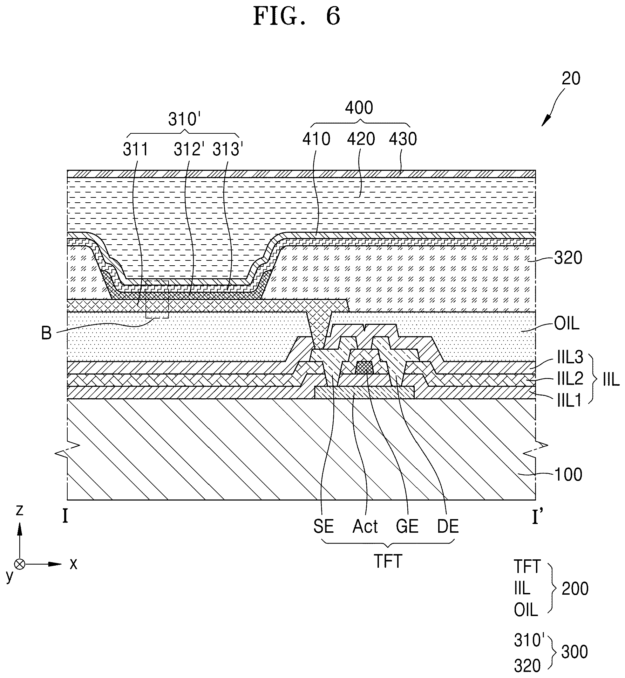

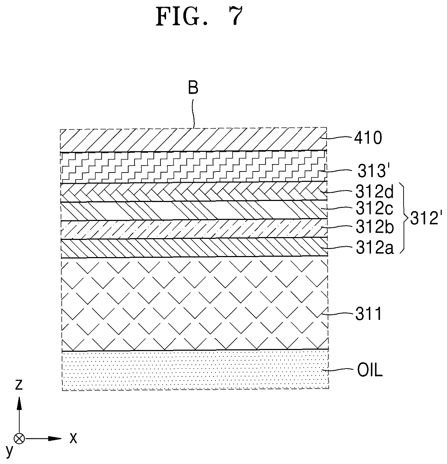

FIG. 6 is a schematic cross-sectional view of a portion of a display apparatus 20 according to a comparative example, and FIG. 7 is an enlarged cross-sectional view of the portion B of FIG. 6. Because the display apparatus 20 according to the comparative example is similar to the display apparatus 10 according to one or more embodiments, the description below will focus on the differences from the display apparatus 10 according to one or more embodiments.

As shown in FIG. 6, in the display apparatus 20 according to the comparative example, a display element 310' may also be electrically connected to a transistor TFT. The display element 310' may be an organic light-emitting diode having, for example, a pixel electrode 311, an opposite electrode 313', and an intermediate layer 312' located therebetween and including an emission layer. The intermediate layer 312' may include a hole transport layer 312a, an emission layer 312b, and an electron transport layer 312c.

However, in the display apparatus 20 according to the comparative example, the opposite electrode 313' of the display element 310' may be composed of a single layer, and the opposite electrode 313' may include silver (Ag) and magnesium (Mg). For example, the opposite electrode 313' of the display element 310' may be a layer composed of silver (Ag) doped with a small amount of magnesium (Mg).

Because the work function of silver (Ag) is about 4.52 eV and the work function of magnesium (Mg) is about 3.66 eV, a layer composed of silver (Ag) but doped with a small amount of magnesium (Mg) may also have a high work function, and therefore may not facilitate the outflow of electrons or anions. Therefore, if (*e.g.,* when) the opposite electrode 313' of the display element 310' is composed of a single layer including silver (Ag) and magnesium (Mg), the intermediate layer 312' of the display element 310' further includes an electron injection layer 312d, as shown in FIG. 7.

For example, the intermediate layer 312' of the display element 310' includes a hole transport layer 312a, an emission layer 312b, an electron transport layer 312c, and an electron injection layer 312d. The electron injection layer 312d is between the electron transport layer 312c and the opposite electrode 313', and the electron injection layer 312d may include ytterbium (Yb). For example, the electron injection layer 312d may be a layer composed only of ytterbium (Yb). Because the work function of ytterbium (Yb) is about 2.60 eV, the electron injection layer 312d composed of ytterbium (Yb) may facilitate the injection of electrons or anions from the opposite electrode 313' to the intermediate layer 312'.

However, magnesium (Mg) and ytterbium (Yb) have higher light absorption rates than silver (Ag) and lithium (Li). For example, based on light in the 450 nm wavelength band, the light absorption rate of magnesium (Mg) is 4.09 % and the light absorption rate of ytterbium (Yb) is 6.02 %. Based on light in the 450 nm wavelength band, the light absorption rate of silver (Ag) is 2.35 % and the light absorption rate of lithium (Li) is 2.03 %. Therefore, because the display element 310' includes magnesium (Mg) and ytterbium (Yb), the optical efficiency of the display apparatus 20 according to the comparative example may be low.

However, in the display apparatus 10 according to one or more embodiments of the present disclosure, the display element 310 includes silver (Ag) and lithium (Li), and does not include magnesium (Mg) and ytterbium (Yb). For example, in the case of the display apparatus 10 according to one or more embodiments, the first electrode layer 313a does not include magnesium (Mg), and the second electrode layer 313b also does not include magnesium (Mg). That is, for example, the opposite electrode 313 does not include magnesium (Mg). Also, the intermediate layer 312 does not include an electron injection layer 312d including ytterbium (Yb). Therefore, because the display element 310 does not include magnesium (Mg) and ytterbium (Yb), the optical efficiency of the display apparatus 10 according to one or more embodiments may be high or improved.

In one or more embodiments, a thickness T313a of the first electrode layer 313a may be equal to or more than about 80 Å and equal to or less than about 150 Å. When the thickness T313a of the first electrode layer 313a is less than 80 Å, the thickness of the first electrode layer 313a is too small for the opposite electrode 313 to sufficiently perform its role. For example, if (*e.g.,* when) the thickness T313a of the first electrode layer 313a is less than 80 Å, the electrical resistance of the opposite electrode 313 may be too high, or the stability of the opposite electrode 313 may be low. When the thickness T313a of the first electrode layer 313a exceeds 150 Å, the change in luminance according to viewing angle change may be too large.

In one or more embodiments, the first electrode layer 313a may include equal to or more than about 0.05 wt% (weight%) and equal to or less than about 1.0 wt% of lithium (Li) based on the total weight of the first electrode layer 313a. The first electrode layer 313a may include equal to or more than about 99.0 wt% and equal to or less than about 99.95 wt% of silver (Ag) based on the total weight of the first electrode layer 313a. Alternatively, in one or more embodiments, the first electrode layer 313a may include equal to or more than about 0.25 wt% and equal to or less than about 0.5 wt% of lithium (Li) based on the total weight of the first electrode layer 313a. The first electrode layer 313a may include equal to or more than about 99.5 wt% and equal to or less than about 99.75 wt% of silver (Ag) based on the total weight of the first electrode layer 313a.

When the first electrode layer 313a includes too little lithium (Li), the lithium (Li) doping effect may not be sufficient, and if (*e.g.,* when) the first electrode layer 313a includes too much lithium (Li), the optical efficiency of the display apparatus 10 may be low or reduced. For example, if (*e.g.,* when) the first electrode layer 313a includes lithium (Li) below the above range based on the total weight of the first electrode layer 313a, the lithium (Li) doping effect may not be sufficient. Therefore, the injection of electrons or anions from the opposite electrode 313 to the intermediate layer 312 may not be facilitated. When the first electrode layer 313a includes lithium (Li) exceeding the above range based on the total weight of the first electrode layer 313a, the first electrode layer 313a includes too much lithium (Li), so the optical efficiency of the display apparatus 10 may be low or reduced.

Generally, although the light absorption rate of lithium (Li) is lower than that of silver (Ag), if (*e.g.,* when) a layer includes silver (Ag) and lithium (Li), the transmittance of the layer is not only affected by the light absorption rates of silver (Ag) and lithium (Li) but may also vary according to the relationship between silver (Ag) and lithium (Li), and/or the like. Accordingly, a layer including silver (Ag) and lithium (Li) decreases in transmittance as the amount of lithium (Li) included in the layer increases. Therefore, if (*e.g.,* when) the first electrode layer 313a includes lithium (Li) exceeding the above range based on the total weight of the first electrode layer 313a, the optical efficiency of the display apparatus 10 may be low or reduced.

In one or more embodiments, a thickness T313b of the second electrode layer 313b may be equal to or more than about 5 Å and equal to or less than about 20 Å. When the thickness T313b of the second electrode layer 313b is less than 5 Å, the amount of reactive metal included in the opposite electrode 313 may not be sufficient, resulting in low stability of the display apparatus 10. When the thickness T313b of the second electrode layer 313b exceeds 20 Å, the second electrode layer 313b may absorb too much light, resulting in low optical efficiency of the display apparatus 10.

Table 1 shows the opposite electrodes (*e.g.,* the composition of the opposite electrodes), emission area reduction rate during high-temperature storage, and optical efficiency of comparative examples and embodiments. The content (*e.g.,* amount) of silver (Ag), lithium (Li), and magnesium (Mg) included in the opposite electrode was obtained by measurement using secondary ion mass spectrometry (SIMS). The emission area reduction rate during high-temperature storage was obtained by measuring the reduction rate of the emission area by using an optical microscope after storing the comparative examples and embodiments in a chamber at 85 °C for 100 hours. The optical efficiency was obtained by measuring the luminance of blue light appearing if (*e.g.,* when) a specific range of voltage was applied to the comparative examples and embodiments. For example, the optical efficiency was obtained by measuring the luminance of light with a y coordinate of 0.042 to 0.044 based on the CIE 1976 color coordinate system after applying a specific range of voltage to the comparative examples and embodiments. The comparative examples and embodiments have the same configurations except for the opposite electrode. However, in the case of the comparative example where the opposite electrode includes silver (Ag) and magnesium (Mg), the intermediate layer includes an electron injection layer including ytterbium (Yb).

**Table 1**

| Classification | Opposite Electrode | Emission Area Reduction Rate During High-Temperature Storage | Optical Efficiency |
|---|---|---|---|
| Comparative Example 1 | AgMg(0.25 wt%) | 30% | 175.0 |
| Comparative Example 2 | AgLi(0.25 wt%) | 40% | 194.5 |
| Comparative Example 3 | AgLi(0.5 wt%) | 30% | 193.4 |
| Comparative Example 4 | AgLi(1.5 wt%)/Li(10 Å) | 0% | 175.2 |
| Comparative Example 5 | AgLi(0.5 wt%)/Li(3 Å) | 25% | 190.3 |
| Comparative Example 6 | AgLi(0.5 wt%)/Li(30 Å) | 0% | 173.7 |
| Example 1 | AgLi(0.5 wt%)/Li(10 Å) | 0% | 184.6 |
| Example 2 | AgLi(0.25 wt%)/Li(10 Å) | 15 % | 194.1 |

Comparative Example 1 includes the intermediate layer 312' and the opposite electrode 313', as shown in FIGS. 6 and 7. For example, the opposite electrode 313' of Comparative Example 1 includes silver (Ag) and magnesium (Mg), and the intermediate layer 312' of Comparative Example 1 includes an electron injection layer 312d including ytterbium (Yb). The opposite electrode 313' of Comparative Example 1 includes 0.25 wt% of magnesium (Mg) based on the total weight of the opposite electrode 313'. The thickness of the opposite electrode 313' of Comparative Example 1 is 115 Å.

Comparative Example 2 and Comparative Example 3 include the intermediate layer 312 as shown in FIG. 4, but include an opposite electrode that does not include the second electrode layer 313b. For example, the opposite electrodes of Comparative Example 2 and Comparative Example 3 include only the first electrode layer 313a. The opposite electrode of Comparative Example 2 includes 0.25 wt% of lithium (Li) based on the total weight of the opposite electrode, and the opposite electrode of Comparative Example 3 includes 0.5 wt% of lithium (Li) based on the total weight of the opposite electrode. The thickness of the opposite electrode 313 of Comparative Example 2 and Comparative Example 3 is 115 Å.

Comparative Example 4 includes the intermediate layer 312 and the opposite electrode 313 as shown in FIG. 4, but the first electrode layer 313a of Comparative Example 4 includes lithium (Li) exceeding 1.0 wt% based on the total weight of the first electrode layer 313a. Specifically, the first electrode layer 313a of Comparative Example 4 includes 1.5 wt% of lithium (Li) based on the total weight of the first electrode layer 313a. The thickness of the first electrode layer 313a of Comparative Example 4 is 105 Å, and the thickness of the second electrode layer 313b of Comparative Example 4 is 10 Å.

Comparative Example 5 includes the intermediate layer 312 and the opposite electrode 313 as shown in FIG. 4, but the thickness of the second electrode layer 313b of Comparative Example 5 is less than 5 Å. Specifically, the thickness of the second electrode layer 313b of Comparative Example 5 is 3 Å. The first electrode layer 313a of Comparative Example 5 includes 0.5 wt% of lithium (Li) based on the total weight of the first electrode layer 313a, and the thickness of the first electrode layer 313a of Comparative Example 5 is 105 Å.

Comparative Example 6 includes the intermediate layer 312 and the opposite electrode 313 as shown in FIG. 4, but the thickness of the second electrode layer 313b of Comparative Example 6 exceeds 20 Å. Specifically, the thickness of the second electrode layer 313b of Comparative Example 6 is 30 Å. The first electrode layer 313a of Comparative Example 6 includes 0.5 wt% of lithium (Li) based on the total weight of the first electrode layer 313a, and the thickness of the first electrode layer 313a of Comparative Example 6 is 105 Å.

Examples 1 and 2 include the intermediate layer 312 and the opposite electrode 313 as shown in FIG. 4, according to embodiments of the present disclosure. The first electrode layers 313a of Examples 1 and 2 include lithium (Li) in an amount more than or equal to 0.05 wt% and less than or equal to 1.0 wt% based on the total weight of the first electrode layer 313a. Specifically, the first electrode layer 313a of Example 1 includes 0.5 wt% of lithium (Li) based on the total weight of the first electrode layer 313a, and the first electrode layer 313a of Example 2 includes 0.25 wt% of lithium (Li) based on the total weight of the first electrode layer 313a. The thicknesses of the second electrode layers 313b of Examples 1 and 2 are equal to or more than about 5 Å and equal to or less than about 20 Å. Specifically, the thicknesses of the second electrode layers 313b of Examples 1 and 2 are each 10 Å. The thicknesses of the first electrode layers 313a of Examples 1 and 2 are each 105 Å.

Referring to Table 1, Comparative Example 1, in which the opposite electrode includes silver (Ag) and magnesium (Mg), has an optical efficiency of 175.0. However, Comparative Example 1 shows a 30 % reduction in emission area during high-temperature storage. Comparative Example 2 and Comparative Example 3, in which the opposite electrode includes silver (Ag) and lithium (Li), have optical efficiencies of 194.5 and 193.4, respectively, which are about 11 % higher than that of Comparative Example 1. Comparative Example 2 and Comparative Example 3 show 40 % and 30 % reductions in emission area during high-temperature storage, respectively. Therefore, Comparative Example 2 and Comparative Example 3 have stability that is similar to that of Comparative Example 1.

Compared to Comparative Example 2 and Comparative Example 3, Examples 1 and 2 further include a layer composed only of lithium (Li) in addition to the layer including silver (Ag) and lithium (Li). Accordingly, Example 1 shows a 0 % reduction in emission area during high-temperature storage, and Example 2 shows a 15 % reduction in emission area during high-temperature storage. Therefore, Examples 1 and 2 have excellent or suitable stability. In addition, Example 1 has an optical efficiency of 184.6, which is about 6 % higher than that of Comparative Example 1. Example 2 has an optical efficiency of 194.1, which is about 11 % higher than that of Comparative Example 1. Therefore, Examples 1 and 2 have excellent or suitable optical efficiency.

Compared to Examples 1 and 2, Comparative Example 4 includes a first metal layer that contains too much lithium (Li). A layer including silver (Ag) and lithium (Li) decreases in transmittance as the amount of lithium (Li) contained in the layer increases. Accordingly, Comparative Example 4 includes a first metal layer containing silver (Ag) and lithium (Li), but has an optical efficiency similar to that of Comparative Example 1. Specifically, Comparative Example 4 has an optical efficiency of 175.2.

Compared to Examples 1 and 2, Comparative Example 5 has a second metal layer that is too thin. Therefore, the amount of reactive metal included in the opposite electrode 313 of Comparative Example 5 is not sufficient, resulting in stability that is similar to that of Comparative Example 1. Specifically, Comparative Example 5 shows a 25 % reduction in emission area during high-temperature storage.

Compared to Examples 1 and 2, Comparative Example 6 has a second metal layer that is too thick. Therefore, Comparative Example 6 has an optical efficiency similar to that of Comparative Example 1 because the second electrode layer absorbs too much light emitted from the emission layer. Specifically, Comparative Example 6 has an optical efficiency of 173.7.

The comparative and example data in Table 1 demonstrate that the disclosed two-layer opposite electrode structure including a first electrode layer of silver (Ag) and lithium (Li) within a controlled composition range and a second electrode layer of lithium (Li) having a controlled thickness-achieves a balance of high optical efficiency and superior stability under high-temperature storage conditions. Unlike single-layer electrodes or configurations with excessive or insufficient lithium content, the disclosed structure minimizes or reduces emission area reduction while maintaining desirable transmittance and electrical properties.

Although the display apparatus 10 has been described above, the disclosure is not necessarily limited thereto. A method of manufacturing the display apparatus 10 may also fall within the scope of the disclosure. A method of manufacturing the display apparatus 10 will be described in more detail below.

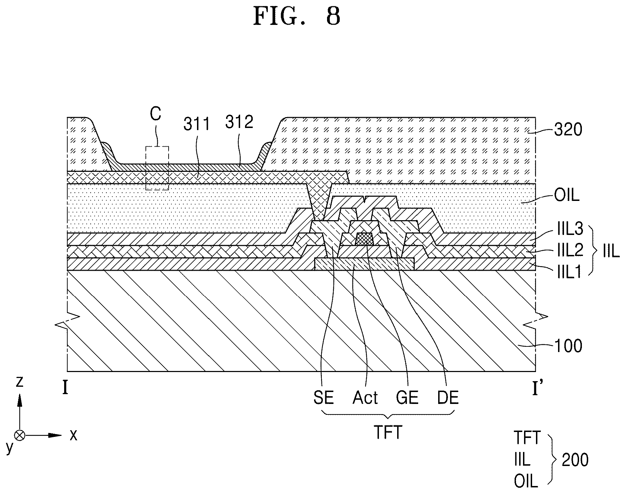

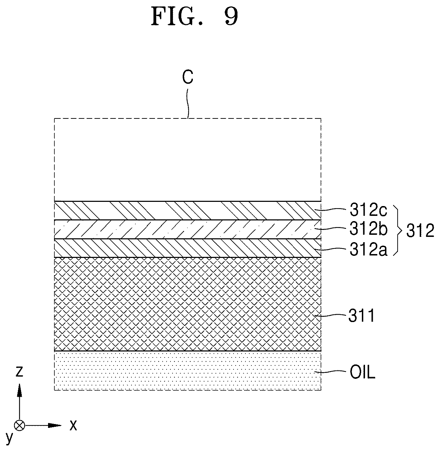

FIGS. 8 to 11 are cross-sectional views schematically illustrating a portion of a manufacturing process for the display apparatus 10 of FIG. 4, according to one or more embodiments. For example, FIGS. 8 to 11 are cross-sectional views schematically illustrating a manufacturing process for the intermediate layer 312 and the opposite electrode 313 of the display apparatus 10 of FIG. 4. For convenience of explanation, in FIGS. 8, 10, and 11, the method of manufacturing the display apparatus will be described based on the cross-section taken along the line I-I' of the display apparatus 10 of FIG. 2, according to one or more embodiments. In one or more embodiments, FIG. 9 is an enlarged cross-sectional view of the portion C of FIG. 8, according to one or more embodiments. Hereinafter, in explaining the method of manufacturing a display apparatus according to one or more embodiments with reference to FIGS. 8 to 11, the same reference numerals as those of FIGS. 4 and 5 refer to the same components, and redundant descriptions thereof may not be provided.

First, as shown in FIG. 8, an intermediate layer 312 may be formed on a pixel electrode 311 arranged on a substrate 100. A pixel circuit layer 200 may be arranged between the substrate 100 and the pixel electrode 311. For example, before forming the pixel electrode 311 on the substrate 100, a semiconductor layer Act may be formed on the substrate 100, and a gate insulating layer IIL1 may be formed on the semiconductor layer Act. Then, a gate electrode GE may be formed on the gate insulating layer IIL1, and a first interlayer insulating layer IIL2 may be formed on the gate electrode GE. Then, a source electrode SE and a drain electrode DE may be formed on the first interlayer insulating layer IIL2, and a second interlayer insulating layer IIL3 may be formed on the source electrode SE and the drain electrode DE. Then, an organic insulating layer OIL may be formed on the second interlayer insulating layer IIL3, and the pixel electrode 311 may be formed on the organic insulating layer OIL. Accordingly, the pixel electrode 311 may be arranged on the substrate 100.

In one or more embodiments, a pixel-defining layer 320 may be formed on the pixel electrode 311 and the organic insulating layer OIL, and the pixel-defining layer 320 may include a pixel opening. The pixel opening may expose the central portion of the pixel electrode 311, and the intermediate layer 312 may be formed such that at least a portion thereof is located within the pixel opening. Accordingly, the intermediate layer 312 may be formed on the pixel electrode 311. For example, the intermediate layer 312 may be formed on the pixel electrode 311 arranged on the substrate 100. In FIG. 8, the intermediate layer 312 is shown as being formed such that the entire intermediate layer 312 is located within the pixel opening, but the disclosure is not necessarily limited thereto. For example, the intermediate layer 312 may be integrally formed across a plurality of pixel electrodes 311. Accordingly, the intermediate layer 312 may be formed such that only a portion of the intermediate layer 312 is located within the pixel opening.

As shown in FIG. 9, the intermediate layer 312 may include the emission layer 312b. The intermediate layer 312 may further include a hole transport layer 312a and an electron transport layer 312c. The hole transport layer 312a may be between the pixel electrode 311 and the emission layer 312b, and the electron transport layer 312c may be arranged on the emission layer 312b. For example, a hole transport layer 312a may be formed on the pixel electrode 311, an emission layer 312b may be formed on the hole transport layer 312a, and an electron transport layer 312c may be formed on the emission layer 312b. As detailed descriptions of the hole transport layer 312a, the emission layer 312b, and the electron transport layer 312c have been provided above with reference to FIG. 4, redundant descriptions related to these may not be provided. For the formation of the pixel circuit layer 200, the pixel-defining layer 320, the pixel electrode 311, and the intermediate layer 312, methods generally available and/or generally utilized in the manufacturing of display apparatuses may be used.

When the display element 310 is provided with a tandem structure, each of the lower emission layer and the upper emission layer of the tandem structure may be integrally formed across a plurality of pixel electrodes 311, and each of the functional layers (*e.g.,* the hole transport layer and/or the electron transport layer) and the charge generation layer of the tandem structure may be integrally formed across a plurality of pixel electrodes 311. Alternatively, in one or more embodiments, each of the lower emission layer and/or the upper emission layer of the tandem structure may be patterned to correspond to the plurality of pixel electrodes 311, while each of the functional layers (*e.g.,* the hole transport layer and/or the electron transport layer) and the charge generation layer of the tandem structure may be integrally formed across the plurality of pixel electrodes 311.

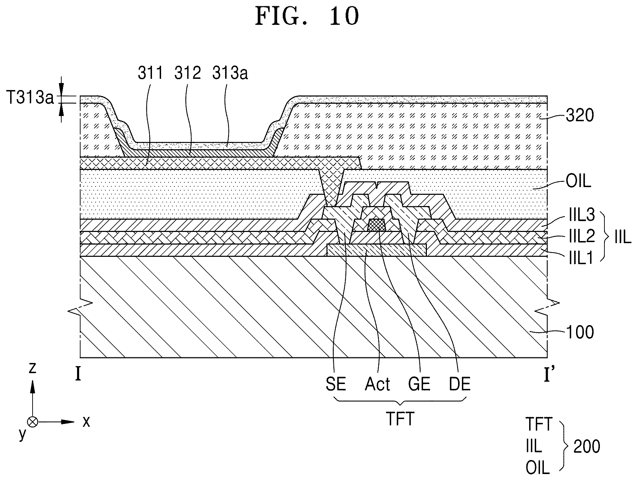

Then, as shown in FIG. 10, a first electrode layer 313a may be formed on the intermediate layer 312. The first electrode layer 313a may include silver (Ag) and lithium (Li). The first electrode layer 313a may not include (*e.g.,* may exclude) magnesium (Mg). For example, the first electrode layer 313a may be formed by co-depositing silver (Ag) and lithium (Li) on the electron transport layer 312c of the intermediate layer 312. For example, the first electrode layer 313a may be directly formed on the electron transport layer 312c including an organic material.

In one or more embodiments, the thickness T313a of the first electrode layer 313a may be equal to or more than about 80 Å and equal to or less than about 150 Å. When the thickness T313a of the first electrode layer 313a is less than 80 Å, the thickness of the first electrode layer 313a is too small for the opposite electrode 313 to sufficiently perform its role. For example, if (*e.g.,* when) the thickness T313a of the first electrode layer 313a is less than 80 Å, the electrical resistance of the opposite electrode 313 may be too high, or the stability of the opposite electrode 313 may be low. When the thickness T313a of the first electrode layer 313a exceeds 150 Å, the change in luminance according to viewing angle change may be too large.

In one or more embodiments, the first electrode layer 313a may include equal to or more than about 0.05 wt% and equal to or less than about 1.0 wt% of lithium (Li) based on the total weight of the first electrode layer 313a. The first electrode layer 313a may include equal to or more than about 99.0 wt% and equal to or less than about 99.95 wt% of silver (Ag) based on the total weight of the first electrode layer 313a. Alternatively, in one or more embodiments, the first electrode layer 313a may include lithium (Li) of equal to or more than about 0.25 wt% and equal to or less than about 0.5 wt% based on the total weight of the first electrode layer 313a. The first electrode layer 313a may include silver (Ag) of equal to or more than about 99.5 wt% and equal to or less than about 99.75 wt% based on the total weight of the first electrode layer 313a.

When the first electrode layer 313a includes lithium (Li) below the above range based on the total weight of the first electrode layer 313a, the lithium (Li) doping effect may not be sufficient, so the injection of electrons or anions from the opposite electrode 313 to the intermediate layer 312 may not be facilitated. When the first electrode layer 313a includes lithium (Li) exceeding the above range based on the total weight of the first electrode layer 313a, the first electrode layer 313a includes too much lithium (Li), so the optical efficiency of the display apparatus 10 may be low or reduced.

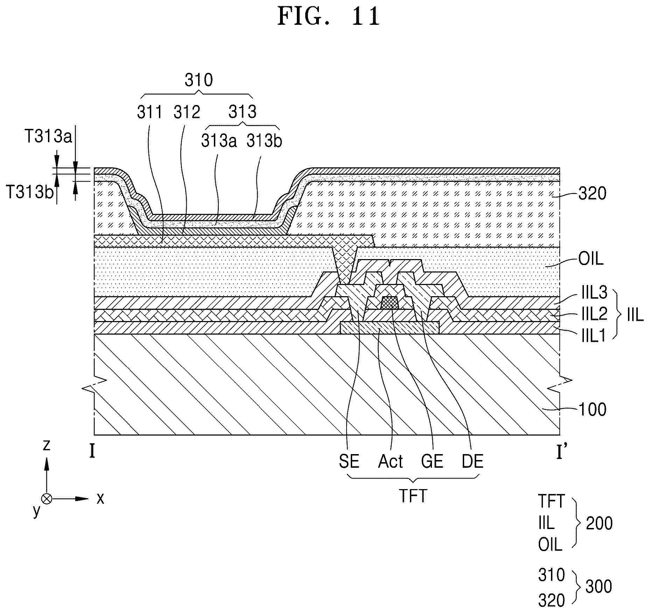

Then, as shown in FIG. 11, a second electrode layer 313b may be formed on the first electrode layer 313a. The second electrode layer 313b may include lithium (Li). For example, the second electrode layer 313b may be formed by depositing lithium (Li) on the first electrode layer 313a. For example, the second electrode layer 313b may be directly formed on the first electrode layer 313a including silver (Ag) and lithium (Li).

In one or more embodiments, the thickness T313b of the second electrode layer 313b may be equal to or more than about 5 Å and equal to or less than about 20 Å. When the thickness T313b of the second electrode layer 313b is less than 5 Å, the amount of reactive metal included in the opposite electrode 313 may not be sufficient, resulting in low stability of the display apparatus 10. When the thickness T313b of the second electrode layer 313b exceeds 20 Å, the second electrode layer 313b may absorb too much light, resulting in low optical efficiency of the display apparatus 10.

According to one or more embodiments configured as described above, a display apparatus, a method of manufacturing the display apparatus, and an electronic apparatus, having excellent or suitable optical efficiency and high stability, may be implemented. However, the scope of the disclosure is not necessarily limited by these effects.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

Further, the use of "may" when describing embodiments of the present disclosure refers to "one or more embodiments of the present disclosure."

As used herein, the terms "use," "using," and "used" may be considered synonymous with the terms "utilize," "utilizing," and "utilized," respectively.

As used herein, the term "substantially," "about," and similar terms are used as terms of approximation and not as terms of degree, and are intended to account for the inherent deviations in measured or calculated values that would be recognized by those of ordinary skill in the art. "Substantially" as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "substantially" may mean within one or more standard deviations, or within ± 30%, 20%, 10%, 5% of the stated value. Also, it should be understood that, even if the terms "about," "approximately," or "substantially" are not expressly recited in a given element (*e.g.,* a claim element), the scope of such element is intended to include variations that are insubstantial or within the understanding of one of ordinary skill in the art. For example, numerical values and ranges provided herein are intended to include tolerances and measurement uncertainties that would be recognized by those skilled in the art, and the elements (*e.g.,* claim elements) should be construed accordingly to encompass such equivalents.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

The display device, electronic device, device for manufacturing the display device, and/or any other relevant devices or components according to embodiments of the present disclosure described herein may be implemented utilizing any suitable hardware, firmware (*e.g.,* an application-specific integrated circuit), software, or a combination of software, firmware, and hardware. For example, the various components of the device may be formed on one integrated circuit (IC) chip or on separate IC chips. Further, the various components of the device may be implemented on a flexible printed circuit film, a tape carrier package (TCP), a printed circuit board (PCB), or formed on one substrate. Further, the various components of the device may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the embodiments of the present disclosure.

A person of ordinary skill in the art, in view of the present disclosure in its entirety, would appreciate that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. It is to be understood that the foregoing is an illustration of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A display apparatus comprising:
a substrate (100);
a pixel electrode (311) on the substrate (100);
an opposite electrode on the pixel electrode (311); and
an intermediate layer (312) between the pixel electrode (311) and the opposite electrode and comprising an emission layer (312b),
wherein the opposite electrode (313) comprises:
a first electrode layer (313a) directly contacting the intermediate layer (312) and comprising silver (Ag) and lithium (Li); and
a second electrode layer (313b) on the first electrode layer (313a) and comprising Li.

2. The display apparatus of claim 1, wherein the intermediate layer (312) further comprises a hole transport layer (312a) between the pixel electrode (311) and the emission layer (312b), and
an electron transport layer (312c) between the opposite electrode (313) and the emission layer (312b).

3. The display apparatus of claim 2, wherein the first electrode layer (313a) directly contacts the electron transport layer (312c).

4. The display apparatus of claim 2 or 3, wherein the electron transport layer (312c) comprises an organic material.

5. The display apparatus of any one of claims 1 to 4, wherein the first electrode layer (313a) comprises Li in an amount equal to or more than 0.05 wt% and equal to or less than 1.0 wt% based on a total weight of the first electrode layer (313a).

6. The display apparatus of any one of claims 1 to 5, wherein a thickness of the second electrode layer (313b) is equal to or more than 5 Å and equal to or less than 20 Å.

7. The display apparatus of any one of claims 1 to 6, wherein the first electrode layer (313a) does not comprise any magnesium (Mg).

8. The display apparatus of claim 1, further comprising an encapsulation layer (430) on the opposite electrode (313) and comprising at least one inorganic encapsulation layer (410) and at least one organic encapsulation layer (420).

9. A method comprising:
forming an intermediate layer (312) comprising an emission layer (312b) on a pixel electrode (311) on a substrate (100);
forming a first electrode layer (313a) comprising silver (Ag) and lithium (Li) on the intermediate layer (312); and
forming a second electrode layer (313b) comprising Li on the first electrode layer (313a),
wherein the method is a method for manufacturing a display apparatus.

10. The method of claim 9, wherein the intermediate layer (312) further comprises:
a hole transport layer (312a) between the pixel electrode (311) and the emission layer (312b); and
an electron transport layer (312c) on the emission layer (312b),
wherein the forming of the first electrode layer (313a) comprises:
co-depositing Ag and Li on the electron transport layer (312c), and
wherein the forming of the second electrode layer (313b) comprises:
depositing Li on the first electrode layer (313a).

11. The method of claim 10, wherein the electron transport layer (312c) comprises an organic material.

12. The method of claim 9, 10 or 11, wherein the first electrode layer (313a) comprises Li in an amount equal to or more than 0.05 wt% and equal to or less than 1.0 wt% based on a total weight of the first electrode layer (313a).

13. The method of any one of claims 9 to 12, wherein a thickness of the second electrode layer (313b) is equal to or more than 5 Å and equal to or less than 20 Å.

14. The method of any one of claims 9 to 13, wherein the first electrode layer (313a) does not comprise any magnesium (Mg).

15. An electronic apparatus comprising:
a processor (12); and
a display apparatus (10) to be controlled by the processor,
wherein the display apparatus (10) is according to any one of claims 1 to 8.
